Europäisches Patentamt

European Patent Office

Office européen des brevets

(19)

(11) Numéro de publication : **0 006 047 B1**

# FASCICULE DE BREVET EUROPÉEN

(12)

(45) Date de publication du fascicule du brevet :
19.05.82

(21) Numéro de dépôt : 79400316.0

(22) Date de dépôt : 21.05.79

(51) Int. Cl.³ : **G 10 K 11/36, H 01 L 41/04, H 03 H 3/04**

(54) **Lames de quartz pour ondes de surface.**

(30) Priorité : 25.05.78 FR 7815560

(43) Date de publication de la demande :
**12.12.79 (Bulletin 79/25)**

(45) Mention de la délivrance du brevet :
**19.05.82 Bulletin 82/20**

(84) Etats contractants désignés :
**CH DE FR GB IT**

(56) Documents cités :
**EP - A - 0 005 953**
**DE - A - 2 312 057**
**US - A - 3 818 382**

(73) Titulaire : **QUARTZ ET ELECTRONIQUE Société anonyme dite:**
**1, rue d'Anjou**
**F-92600 Asnières (FR)**

(72) Inventeur : **Gagnepain, Jean-Jacques**
**F-25170 Recologne (FR)**
Inventeur : **Hauden, Daniel**
**10, Cité Parc des Chaprais 131, rue de Belfort**
**F-25000 Besançon (FR)**
Inventeur : **Pegeot, Claude**
**32, avenue Rudé**
**F-78500 Sartrouville (FR)**
Inventeur : **Michel, Monique**
**17, rue de la Chapelle**
**F-67400 Ostwald (FR)**

(74) Mandataire : **Weinmiller, Jürgen**
**Zeppelinstrasse 63**
**D-8000 München 80 (DE)**

Imprimerie Jouve, 18, rue St-Denis, 75001 Paris, France

## Lames de quartz pour ondes de surface

L'invention se rapporte aux lames de quartz pour ondes de surface.

Le cristal de quartz est utilisé pour la réalisation de lignes à retard et de résonateurs à ondes de surface.

Parmi les principales applications du quartz on peut citer les oscillateurs et les filtres.

Sous l'effet de la température, d'une part les caractéristiques de l'onde de surface sont modifiées par variation des constantes élastiques du cristal et de sa masse spécifique, d'autre part les dimensions du substrat changent. Ceci se traduit par une variation du retard de la ligne ou de la fréquence propre du résonateur, donc par conséquent par une variation de la fréquence de l'oscillateur ou des caractéristiques du filtre.

La variation de fréquence peut être représentée par la relation polynomiale suivante :

$$f(T) = f(T_o) \left( 1 + \alpha_f^{(1)} (T - T_o) + \alpha_f^{(2)} (T - T_o)^2 + \alpha_f^{(3)} (T - T_o)^3 \right)$$

Les coefficients $\alpha_f^{(n)}$ sont appelés coefficents de température et caractérisent la sensibilité du dispositif à ondes de surface à la température.

Il est bien connu que la coupe de lames s'effectue par référence à un trièdre OXYZ défini par trois axes OX, OY, OZ qui sont :

— un axe électrique, OX,

— un axe mécanique, OY, faisant un angle de 90° avec l'axe OX,

— l'axe optique OZ du cristal.

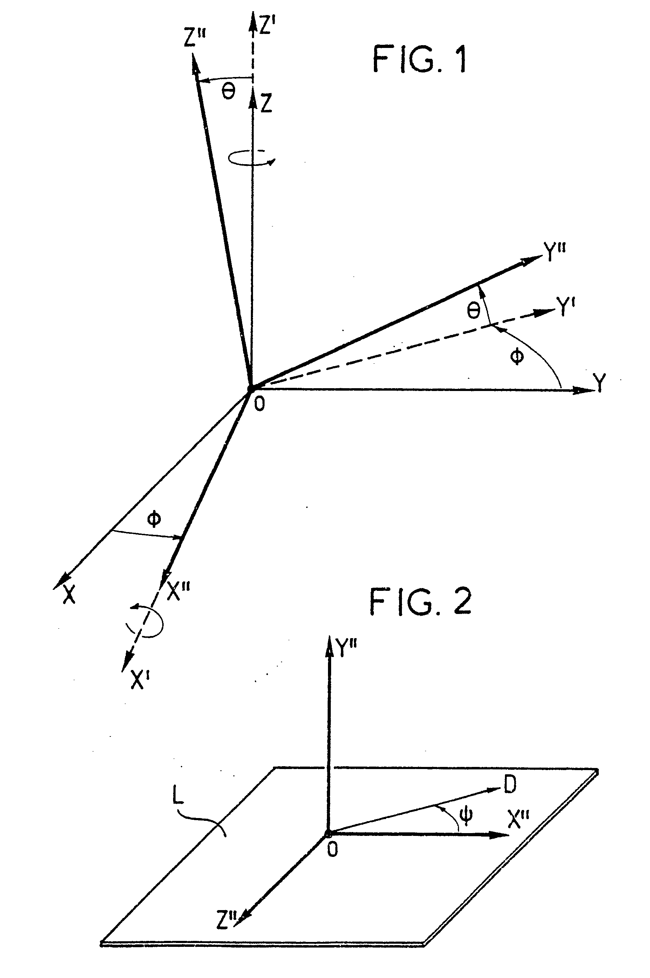

Classiquement on définit un plan de coupe par deux angles de rotation $\phi$ et $\theta$ l'angle $\phi$ correspondant à une première rotation du trièdre de référence OXYZ autour de l'axe OZ ; on obtient ainsi le trièdre OX'-Y'Z', figure 1, l'axe OZ' étant confondu avec OZ. L'angle $\theta$ correspond à une rotation du trièdre OX'-Y'Z' autour de l'axe OX' ; on obtient ainsi le trièdre OX"Y"Z", avec l'axe OX" confondu avec OX'. Le plan de coupe, donc le plan des lames, est le plan OX"Z".

Pour les coupes connues, telles que par exemple AT, BT, Y, ST, l'angle de première rotation $\phi$ est nul.

Lorsque l'angle de première rotation $\phi$ n'est pas nul, les coupes sont dites à double rotation, et les lames sont dans le plan OX"Z", figure 1.

Les coupes de quartz utilisées actuellement pour la majorité des applications à ondes de surface sont les coupes à simple rotation, Y, Y + $\theta$ et ST dans lesquelles la direction de propagation, en surface, est parallèle à l'axe cristallographique OX. Ces coupes présentent les caractéristiques suivantes :

Coupe Y, X : $\alpha_f^{(1)} = + 24$ ppm/°C $\alpha_f^{(2)} = - 15 \cdot 10^{-3}$ ppm/°C$^2$, ce qui conduit à une variation relative de fréquence $\Delta f/f$ égale à 700 ppm de 0° à 50 °C et égale à 1 100 ppm de $- 20°$ à 75 °C

Coupe ST, X : $\alpha_f^{(1)} = 0$ $\alpha_f^{(2)} = - 40 \cdot 10^{-3}$ ppm/°C$^2$, ce qui conduit à $\Delta f/f$ égale à 30 ppm de 0° à 50 °C et égale à 90 ppm de $- 20°$ à 75 °C.

Parmi les coupes utilisées actuellement, la coupe ST est celle qui présente les meilleures caractéristiques en température puisque $\alpha_f^{(1)} = 0$ ; les coefficients de température $\alpha_f^{(1)}$ et $\alpha_f^{(2)}$ ne sont simultanément nuls pour aucune des coupes utilisées.

Il est également connu que la variation relative de fréquence dans les lames de quartz à simple rotation utilisées en ondes de surface, est supérieure à celle des lames à simple rotation utilisées en ondes de volume ; ainsi pour la coupe AT, très utilisée en ondes de volume, la variation relative de fréquence est $\Delta f/f = \pm 5$ ppm de $- 20$ °C à 80 °C.

L'invention a pour objet une lame de quartz dont la variation relative de fréquence, dans une utilisation en ondes de surface, et pour une même plage de température, est inférieure à celle des lames selon la coupe ST.

Un autre objet de l'invention est une lame de quartz dont la variation relative de fréquence, dans une utilisation en ondes de surface et pour une même plage de température, est du même ordre que celle des lames selon la coupe AT utilisée en ondes de volume.

Une lame selon l'invention est obtenue selon une coupe à double rotation. Une telle lame est définie dans la revendication 1. La figure 2 représente une lame L obtenue dans le plan OX"Z" représenté figure 1. L'axe OY" est perpendiculaire à la lame L.

Dans le plan de la lame une droite D, faisant un angle $\psi$ avec l'axe OX", représente la direction de propagation en surface ; lorsque la lame L est munie, selon les techniques connues, de transducteurs, un transducteur émetteur et au moins un transducteur récepteur, la droite D représente la direction de propagation des ondes de surface du transducteur émetteur au transducteur récepteur.

Les angles $\phi$, $\theta$ et $\psi$ d'une lame selon l'invention sont liés par la relation :

$$\phi - \theta - \psi = 21° \ 42' \pm 8' \qquad (1)$$

Lorsque les angles $\phi$, $\theta$ et $\psi$ sont compris entre les valeurs indiquées ci-après :

$$6° \leqslant \phi \leqslant 10° \quad (2)$$
$$-41° \ 45' \leqslant \theta \leqslant -38° \ 55' \quad (3)$$
$$26° \leqslant \psi \leqslant 28° \quad (4)$$

la variation relative de fréquence est inférieure à 15 ppm de 0 °C à 50 °C, et inférieure à 45 ppm de − 20° à 75 °C.

Dans les limites indiquées par les relations (2), (3) et (4), et toujours en satisfaisant la relation (1), les coefficients $\alpha_f^{(1)}$ et $\alpha_f^{(2)}$ sont quasiment nuls simultanément, pour les lames suivantes :

1. $\left. \begin{array}{l} \phi = 9° \ 48' \\ \theta = -39° \\ \psi = 27° \end{array} \right\}$ $\alpha_f^{(1)} = 0$, $\alpha_f^{(2)} \simeq 0,65 \cdot 10^{-3}$ ppm/°C², $\alpha_f^{(3)} = 64 \cdot 10^{-6}$ ppm/°C³

Ceci conduit à

$$\Delta f/f \leqslant 2 \text{ ppm de } 0° \text{ à } 50 °C$$

et

$$\Delta f/f \leqslant 10 \text{ ppm de } -20° \text{ à } 75 °C$$

2. $\left. \begin{array}{l} \phi = 6° \ 20' \\ \theta = -41° \ 30' \\ \psi = 26° \end{array} \right\}$ $\alpha_f^{(1)} = 0$, $\alpha_f^{(2)} = 0$, $\alpha_f^{(3)} = -23 \cdot 10^{-6}$ ppm/°C³

Ceci conduit à

$$\Delta f/f \leqslant 1 \text{ ppm entre } 0° \text{ et } 50 °C$$

et

$$\Delta f/f \leqslant 4 \text{ ppm entre } -20° \text{ et } 75 °C$$

Une lame particulièrement intéressante est celle où les trois coefficients de température de la fréquence sont voisins de zéro ; elle est définie par les angles :

$\left. \begin{array}{l} \phi = 7° \\ \theta = -40° \ 54' \\ \psi = 26° \ 12' \end{array} \right\}$ $\alpha_f^{(1)} = 0$, $\alpha_f^{(2)} = 0$, $\alpha_f^{(3)} = 1,2 \cdot 10^{-6}$ ppm/°C³

Ceci conduit à :

$$\Delta f/f \leqslant 0,2 \text{ ppm entre } 0 °C \text{ et } 50 °C$$
$$\Delta f/f \leqslant 0,5 \text{ ppm entre } -20 °C \text{ et } 75 °C$$
$$\Delta f/f \leqslant 2 \text{ ppm entre } -60 °C \text{ et } 110°$$

La variation relative de fréquence pour cette dernière lame, est inférieure à celle d'une lame AT qui est de l'ordre de ± 5 ppm dans la gamme de température de − 20 °C à 80 °C ; d'autre part elle est du même ordre, mais dans une plage de température bien plus grande, de − 60 °C à 110 °C, ce qui permet d'utiliser ces lames en ondes de surface dans une gamme de températures plus importante que les lames ST ou Y, avec des performances comparables à celles des lames utilisées en ondes de volume.

La précision sur les angles $\phi$ et $\theta$ définissant une lame est de ± 30″ ; la précision sur l'angle $\psi$ est de ± 2′ et correspond à la précision avec laquelle sont déposés les transducteurs en surface de la lame L.

Des relations (1) et (4) entre les angles $\phi$, $\theta$ et $\psi$ on en déduit que les angles de première et seconde rotation $\phi$ et $\theta$, repérant la taille de la lame de quartz, satisfont à la relation $47° \ 34' \leqslant \phi - \theta \leqslant 49° \ 50'$, compte tenu bien entendu des relations (2) et (3). La lame ainsi taillée est alors munie de transducteurs définissant une direction de propagation faisant l'angle $\psi$ avec l'axe OX′ de manière à vérifier les relations (1) et (4).

De la relation (1) entre les angles $\phi$, $\theta$ et $\psi$ on en déduit que pour un angle $\psi_1$ donné les angles $\phi$ et $\theta$ sont reliés par la relation :

$$\phi - \theta = 21° \ 42' + \psi_1 \pm 8' \quad (5)$$

La relation 5 présente un grand intérêt pratique. En effet, si l'on définit des lames par des angles de coupe $\phi_1$ et $\theta_1$ satisfaisant la relation (5) et que pratiquement un angle, ou les deux angles, n'ont pas la

3

**0 006 047**

valeur désirée, la relation (5) n'est pas vérifiée. Il est possible que la relation

$$\phi_1 - \theta_1 - \psi_2 = 21° \ 42' \pm 8'$$

soit satisfaite avec un angle $\psi_2$, compris entre 26° et 18°, ce qui revient à adopter pour l'angle $\psi$ la valeur $\psi_2$, au lieu de la valeur $\psi_1$ initialement prévue. L'angle $\psi$ étant lié au dépôt des transducteurs, on peut donc rattraper, au moment de leur dépôt, un défaut dans les angles de coupe $\phi_1$ et $\theta_1$, ceci bien entendu compte tenu de la relation (4) qui définit les limites de variation de l'angle $\psi$.

Les angles donnés par les relations (2) (3) (4) correspondent à un certain domaine de l'espace ; celui-ci n'est pas le seul, dans le quartz.

D'autres domaines de l'espace permettent la coupe de lames de quartz ayant les mêmes propriétés que celles obtenues dans le domaine décrit ci-avant. Ils sont déterminés par des considérations de symétrie indiquées ci-après.

1. Symétrie de rotation sur l'angle $\phi$ (autour de OZ) de $2\pi/3$
$Z(\theta, \phi, \psi) = Z(\theta, \phi + 2\pi/3, \psi) = Z(\theta, \phi + 4\pi/3, \psi)$ quels que soient les angles $\theta$, $\phi$ et $\psi$

2. $Z(-\theta, \pi - \phi, \psi = Z(\theta, \phi, \psi)$ la symétrie de rotation (1) est conservée

3. $Z(\theta, -\phi, \pi - \psi) = Z(\theta, \phi, \psi)$ les symétries (1) et (2) sont conservées.

Les coupes ainsi définies permettent de réaliser des dispositifs à ondes de surface plus stables en température. En particulier des oscillateurs pour lesquels il ne sera pas nécessaire d'utiliser des thermostats de très grande précision, qui sont souvent incompatibles avec des exigences d'encombrement et de consommation. Il est même envisageable dans certains cas de pouvoir se passer de tout thermostat. Les mêmes remarques s'appliquent au cas des filtres et des lignes à retard.

**Revendications**

1. Lame de quartz pour ondes de surface, définie par un repère OXYZ dans lequel les angles OX, OY, OZ sont respectivement un axe électrique, un axe mécanique, et l'axe optique d'un cristal, caractérisée par le fait qu'elle est taillée selon une coupe à double rotation définie par deux angles $\phi$, $\theta$, $\phi$ étant un angle de première rotation autour de l'axe optique OZ et $\theta$ un angle de seconde rotation autour d'un axe OX' faisant l'angle $\phi$ avec l'axe électrique OX après la première rotation, que l'angle de première rotation $\phi$ est compris entre 6° et 10°, limites incluses, que l'angle $\theta$ est compris entre $- 41° \ 45'$ et $- 38° \ 55'$, limites incluses, et que les angles $\phi$ et $\theta$ vérifient la relation :

$$47° \ 34' \leqslant \phi - \theta \leqslant 49° \ 50'$$

2. Lame de quartz selon la revendication 1, caractérisée par le fait qu'elle comporte en surface des transducteurs définissant une direction de propagation des ondes de surface faisant un angle $\psi$ avec l'axe OX' en surface de la lame, que l'angle $\psi$ est compris entre 26° et 28°, limites incluses, et que les angles $\phi$, $\theta$ et $\psi$ sont liés par la relation :

$$\phi - \theta - \psi = 21° \ 42' \pm 8'$$

3. Lame de quartz selon l'une des revendications 1 et 2, caractérisée par le fait que les angles $\phi$, $\theta$ et $\psi$ définis dans le repère OXYZ lié à un axe électrique du cristal de quartz satisfont à la relation de symétrie dans le cristal :

$$Z(\theta, \phi + 2k\pi/3, \psi) = Z(\theta, \phi, \psi)$$

k prenant les valeurs 1 et 2.

4. Lame de quartz selon l'une des revendications 1, 2 et 3, caractérisée par le fait que les angles $\phi$, $\theta$ et $\psi$ satisfont à la relation de symétrie dans le cristal :

$$Z(-\theta, \pi - \phi, \psi) = Z(\theta, \phi, \psi)$$

5. Lame de quartz selon l'une des revendications 1, 2, 3 et 4, caractérisée par le fait que les angles $\phi$, $\theta$ et $\psi$ satisfont à la relation de symétrie dans le cristal :

$$Z(\theta, -\phi, \pi - \psi) = Z(\theta, \phi, \psi)$$

6. Lame de quartz selon l'une des revendications 1, 2, 3, 4 et 5, caractérisée par le fait que les angles $\phi$, $\theta$ et $\psi$ ont pour valeurs :

$$\phi = 9° \ 48', \ \theta = - 39°, \ \psi = 27°$$

4

7. Lame de quartz selon l'une des revendications 1, 2, 3, 4 et 5, caractérisée par le fait que les angles $\phi$, $\theta$ et $\psi$ ont pour valeurs :

$$\phi = 6° \; 20', \; \theta = -41° \; 30', \; \psi = 26°$$

8. Lame de quartz selon l'une des revendications 1, 2, 3, 4 et 5, caractérisée par le fait que les angles $\phi$, $\theta$ et $\psi$ ont pour valeurs :

$$\phi = 7°, \; \theta = -40° \; 54', \; \psi = 26° \; 12'$$

**Claims**

1. A quartz plate for surface waves, said plate being defined by a reference OXYZ in which the angles OX, OY, and OZ are respectively an electrical axis, a mechanical axis and the optical axis of a crystal, characterized in that said plate is cut with a double rotation defined by two angles $\phi$ and $\theta$, $\phi$ being an angle of first rotation about the optical axis OZ and $\theta$ being an angle of second rotation about an axis OX' which forms the angle $\phi$ with the electrical axis OX after the first rotation, the angle of first rotation $\phi$ lying between 6° and 10° inclusive, the angle $\theta$ lying between $-41° \; 45'$ and $-38° \; 55'$ inclusive and the angles $\phi$ and $\theta$ satisfying the equation :

$$47° \; 34' \leqslant \phi - \theta \leqslant 49° \; 50'$$

2. A quartz plate according to claim 1, characterized in that it comprises, on its surface, transducers which define a direction of propagation of the surface waves which form an angle $\psi$ with the axis OX' at the surface of the plate, the angle $\psi$ lying between 26° and 28° inclusive, and the angle $\phi$, $\theta$ and $\psi$ being related by the equation :

$$\phi - \theta - \psi = 21° \; 42' \pm 8'$$

3. A quartz plate according to one of the claims 1 to 2, characterized in that the angles $\phi$, $\theta$ and $\psi$ defined by the reference OXYZ related to an electrical axis of the quartz crystal satisfy the relation of symmetry in the crystal :

$$Z(\theta, \; \phi + 2k\pi/3, \; \psi) = Z(\theta, \; \phi, \; \psi)$$

k assuming the values 1 and 2.

4. A quartz plate according to anyone of the claims 1, 2 and 3, characterized in that the angles $\phi$, $\theta$ and $\psi$ satisfy the relation of symmetry in the crystal :

$$Z(-\theta, \; \pi - \phi, \; \psi) = Z(\theta, \; \phi, \; \psi)$$

5. A quartz plate according to anyone of the claims 1, 2, 3 and 4, characterized in that the angles $\phi$, $\theta$ and $\psi$ satisfy the relation of symmetry in the crystal :

$$Z(\theta, \; -\phi, \; \pi - \psi) = Z(\theta, \; \phi, \; \psi)$$

6. A quartz plate according to anyone of the claims 1, 2, 3, 4 and 5, characterized in that the values of the angles $\phi$, $\theta$ et $\psi$ are :

$$\phi = 9° \; 48', \; \theta = -39°, \; \psi = 27°$$

7. A quartz plate according to anyone of the claims 1, 2, 3, 4 and 5, characterized in that the values of the angles $\phi$, $\theta$ et $\psi$ are :

$$\phi = 6° \; 20', \; \theta = -41° \; 30', \; \psi = 26°$$

8. A quartz plate according to anyone of the claims 1, 2, 3, 4 and 5, characterized in that the values of the angles $\phi$, $\theta$ and $\psi$ are :

$$\phi = 7°, \; \theta = -40° \; 54', \; \psi = 26° \; 12'$$

**Ansprüche**

1. Quarzplättchen für Oberflächenwellen, definiert durch ein Netz OXYZ, in dem die Winkel OX, OY,

5

OZ je eine elektrische Achse, eine mechanische Achse und die optische Achse eines Kristalls sind, dadurch gekennzeichnet, daß es gemäß einem Schnitt mit zweifacher Drehung, definiert durch zwei Winkel $\phi$, $\theta$, geschnitten ist, wobei $\phi$ ein Winkel erster Drehung um die optische Achse OZ und $\theta$ ein Winkel zweiter Drehung um eine Achse OX' ist, die mit der elektrischen Achse OX nach der ersten Drehung einen Winkel $\phi$ einschließt, daß der Winkel erster Drehung $\phi$ zwischen 6° und 10° einschließlich der Grenzwerte liegt, daß der Winkel $\theta$ zwischen $-41°$ 45' und $-38°$ 55' einschließlich der Grenzwerte liegt und daß die Winkel $\phi$ und $\theta$ die Beziehung erfüllen :

$$47° \ 34' \leqslant \phi - \theta \leqslant 49° \ 50'$$

2. Quarzplättchen nach Anspruch 1, dadurch gekennzeichnet, daß es auf der Oberfläche Übertrager aufweist, die für die Oberflächenwellen eine Fortpflanzungsrichtung definieren, welche einen Winkel $\psi$ mit der Achse OX' auf der Plättchenoberfläche einschließt, daß der Winkel $\psi$ zwischen 26° und 28° einschließlich der Grenzwerte liegt und daß die Winkel $\phi$, $\theta$ und $\psi$ die Beziehung erfüllen :

$$\phi - \theta - \psi = 21° \ 42' \pm 8'$$

3. Quarzplättchen nach einem der Ansprüche 1 bis 2, dadurch gekennzeichnet, daß die Winkel $\phi$, $\theta$ und $\psi$, die im an eine elektrische Achse des Quarzkristalls gebundenen Koordinatennetz OXYZ definiert sind, die Symmetriebeziehung im Kristall erfüllen :

$$Z(\theta, \ \phi + 2k\pi/3, \ \psi) = Z(\theta, \ \phi, \ \psi)$$

wobei k die Werte 1 und 2 annimmt.

4. Quarzplättchen nach einem der Ansprüche 1, 2 und 3, dadurch gekennzeichnet, daß die Winkel $\phi$, $\theta$ und $\psi$ die Symmetriebeziehung im Kristall erfüllen :

$$Z(-\theta, \ \pi - \phi, \ \psi) = Z(\theta, \ \phi, \ \psi)$$

5. Quarzplättchen nach einem der Ansprüche 1, 2, 3 und 4, dadurch gekennzeichnet, daß die Winkel $\phi$, $\theta$ und $\psi$ die Symmetriebeziehung im Kristall erfüllen :

$$Z(\theta, \ -\phi, \ \pi - \psi) = Z(\theta, \ \phi, \ \psi)$$

6. Quarzplättchen nach einem der Ansprüche 1, 2, 3, 4 und 5, dadurch gekennzeichnet, daß die Winkel $\phi$, $\theta$ und $\psi$ folgende Werte annehmen :

$$\phi = 9° \ 48', \ \theta = -39°, \ \psi = 27°$$

7. Quarzplättchen nach einem der Ansprüche 1, 2, 3, 4 und 5, dadurch gekennzeichnet, daß die Winkel $\phi$, $\theta$ und $\psi$ folgende Werte annehmen :

$$\phi = 6° \ 20', \ \theta = -41° \ 30', \ \psi = 26°$$

8. Quarzplättchen nach einem der Ansprüche 1, 2, 3, 4 und 5, dadurch gekennzeichnet, daß die Winkel $\phi$, $\theta$ und $\psi$ folgende Werte annehmen :

$$\phi = 7°, \ \theta = -40° \ 54', \ \psi = 26° \ 12'$$

FIG. 1

FIG. 2